# EUROPÄISCHE PATENTANMELDUNG

(11) **EP 1 119 230 A2**
(43) Veröffentlichungstag der Anmeldung: **25.07.2001**
(21) Anmeldenummer: 00128398.5
(22) Anmeldetag: 22.12.2000
(51) Int. Cl.: H05K 7/20

(54) **Kühlgerät**

(30) Priorität: 19.01.2000 DE 20000863 U
(71) Anmelder: Knürr-Mechanik für die Elektronik AG, D-81829 Munchen (DE)
(72) Erfinder: Willkommem, Thomas Dr., 64319 Pfungstadt (DE)
(74) Vertreter: Heim, Hans-Karl, Dipl.-Ing.

(57) **Zusammenfassung**

Die Erfindung betrifft ein Kühlgerät mit einem Luftführungskanal für Kühlluft, welche einen Verdampfer mit senkrecht angeordneten Lamellen horizontal durchströmt, und mit einem Luftleitblech, welches unterhalb des Verdampfers angeordnet ist und Kondenswasser des Verdampfers aufnimmt.

Für eine störungsfreie Kühlluftströmung und eine kontrollierte Kondenswasserabführung ist der Verdampfer derart auf dem Luftleitblech angeordnet, dass die Lamellen des Verdampfers bis zu dem Luftleitblech reichen. Das Luftleitblech und der Verdampfer sind geneigt angeordnet, wobei die Neigung zu einer freien, in den Luftführungskanal des Kühlgerätes gerichteten, rückseitigen Kante des Luftleitbleches abfällt.

## Beschreibung

Die Erfindung betrifft ein Kühlgerät für einen Schaltschrank gemäß dem Oberbegriff des Anspruchs 1.

Bei Schaltschrank-Kühlgeräten, welche nach dem Funktionsprinzip einer Kompressionskältemaschine arbeiten, kann es im Bereich des Verdampfers zur Kondenswasserbildung kommen. Das Kondenswasser tropft vom Verdampfer ab und wird von der durch den Verdampfer strömenden Luft mitgerissen. Um ein Eintreten von Kondenswasser in den Schaltschrank zu vermeiden, sind Vorrichtungen zur Kondenswasserabscheidung bekannt (DE 196 41 552 C1, DE 197 12 474 C1, DE 197 22 619 C2).

Außerdem sind Kühlgeräte für Schaltschränke bekannt, bei denen die Kühlluft den Verdampfer horizontal durchströmt (Kühlgerät ACU der KNÜRR-Mechanik für die Elektronik AG). Das Kondenswasser fließt entlang der senkrecht stehenden Lamellen des Verdampfers nach unten und wird auf einem Luftleitblech gesammelt. Das Luftleitblech und der Verdampfer sind exakt horizontal angeordnet. Das Luftleitblech ist als eine rückseitig offene Wanne ausgebildet, so dass das Kondenswasser zur rückseitigen Kante des Luftleitbleches fließt, dort regellos abtropft und von der strömenden Kühlluft mitgerissen wird.

Es ist deshalb erforderlich, zwischen dem Verdampfer und einer Luftaustrittsöffnung eine der bekannten Vorrichtungen zur Kondenswasserabscheidung anzuordnen, was mit erhöhten Kosten verbunden ist und zu einer nachteiligen Beeinflussung der Kühlleistung führen kann.

Der Erfindung liegt die **Aufgabe** zugrunde, ein Kühlgerät zu schaffen, welches eine strörungsfreie Kühlluftströmung und eine kontrollierte Kondenswasserabführung gewährleistet und keine zusätzlichen Vorrichtungen zur Kondenswasserabscheidung erfordert.

Erfindungsgemäß wird die Aufgabe durch die Merkmale des Anspruchs 1 gelöst. Vorteilhafte und zweckmäßige Ausgestaltungen sind in den Unteransprüchen und in der Figurenbeschreibung enthalten.

Die Erfindung basiert auf dem Grundgedanken, die Kondenswasserableitung so zu gestalten, dass das Kondenswasser von der Bildung an den Oberflächen der Verdampferrohre und der vertikal angeordneten Lamellen bis hin zu einer Kondenswasserwanne bzw. einer Kondenswasserableitung in Kontakt mit Bauteilen oder Festkörpern steht und dass die dabei auftretenden Kohäsionskräfte in Bezug auf die Strömungsgeschwindigkeit der Kühlluft stark genug sind, um zu verhindern, dass die vorbeiströmende Kühlluft Kondenswassertropfen mitreißt.

Erfindungsgemäß ist ein Verdampfer, welcher vertikal ausgerichtete Kühllamellen aufweist, derart auf einem Luftleitblech angeordnet, dass die Lamellen des Verdampfers bis zu dem Luftleitblech reichen und dieses kontaktieren. Das sich auf den Kühllamellen niederschlagende Kondenswasser gleitet unter Einwirkung der Schwerkraft zu den unteren Rändern der Lamellen und von diesen auf das Luftleitblech. Erfindungsgemäß sind das Luftleitblech und der Verdampfer geneigt angeordnet, wobei die Neigung zu einer freien, in den Luftführungskanal des Kühlgerätes gerichteten, rückseitigen Kante des Luftleitbleches abfällt.

Indem das Luftleitblech und der Verdampfer schräg nach hinten geneigt werden, kann das Kondenswasser zu der rückseitigen Kante des Luftleitbleches fließen.

In einer vorteilhaften Ausbildung ist die rückseitige Kante des Luftleitbleches mit einer Ablaufrinne versehen, in welche das Kondenswasser unter ständigem Kontakt mit dem Luftleitblech fließen kann.

In einer ersten Ausbildung sind das Luftleitblech und der Verdampfer nur nach hinten, das heißt zu der rückseitigen Kante des Luftleitbleches, geneigt angeordnet, und die Ablaufrinne welche beispielsweise an einem nahezu senkrechten Schenkel angeformt ist, verläuft schräg nach unten in Richtung Gehäuseseitenwand. Auf diese Weise wird ein Rückstau des Kondenswassers vermieden.

Wenn die Ablaufrinne bis zu wenigstens einer Gehäuseseitenwand verlängert ist, kann mit Hilfe einer entsprechend dimensionierten Öffnung ein Abfließen des Kondenswassers entlang der Gehäuseseitenwand gewährleistet werden.

Es ist zweckmäßig, in einem unteren Bereich des Kühlgerätes, insbesondere unterhalb eines Lüfters, welcher vorteilhaft im Bereich einer Austrittsöffnung für den Kühlluftstrom angeordnet ist, eine Kondenswasserrinne im Bereich der Gehäuseseitenwand oder eine Kondenswasserwanne, beispielsweise im Bereich einer Rückwand anzuordnen.

Die Ablaufrinne kann an ihrem freien, unteren Ende auch mit einer Kondenswasserauffangvorrichtung, beispielsweise einem Stutzen oder einem Trichter, verbunden sein bzw. bis zu diesem reichen und über die Kondenswasserauffangvorrichtung an eine Kondenswasserableitung angeschlossen sein.

In einer alternativen Ausbildung ist im Bereich der rückseitigen Kante eine Tropfkante ausgebildet, die mit wenigstens einem Abtropfpunkt versehen ist.

Es ist fertigungstechnisch vorteilhaft, dass die Tropfkante als eine nahezu senkrechte Abkantung des Luftleitbleches im Bereich der rückseitigen Kante ausgebildet werden kann. Ein oder auch zwei Abtropfpunkte, welche bevorzugt an oder nahe den Gehäuseseitenwänden vorgesehen sind, können durch eine sich verbreiternde Abkantung gebildet werden. Das nach hinten geneigte Luftleitblech ist dann im Bereich der rückseitigen Kante waagerecht, jedoch im Bereich der Tropfkante mit wenigstens einer Neigung zu einer der Gehäuseseitenwände ausgebildet, so dass das Kondenswasser an der Tropfkante entlang bis zu dem wenigstens einen Abtropfpunkt gleiten kann.

Wenn die Tropfkante bis zu einer Gehäuseseitenwand reicht, kann das Kondenswasser an dieser bis in eine Kondenswasserrinne fließen, welche insbesondere unterhalb des Lüfters im Bereich der Gehäuseseitenwand angeordnet ist.

Alternativ kann der Abtropfpunkt der Tropfkante auch über eine Kondenswasserableitung zu einer Rückwand des Kühlgerätes geführt werden. Zweckmäßigerweise ist die Kondenswasserableitung schräg nach unten geneigt angeordnet, so dass das Kondenswasser ohne Stau zur Rückwand fließen kann und entlang dieser Rückwand in eine Kondenswasserwanne gelangt. Es besteht auch die Möglichkeit, unterhalb des Abtropfpunktes eine Auffangvorrichtung anzuordnen und diese an eine Kondenswasserableitung anzuschließen.

In einer weiteren alternativen Ausbildung sind das Luftleitblech und der Verdampfer nicht nur schräg nach hinten zur Rückwand, sondern auch zu einer der Gehäuseseitenwände geneigt angeordnet, so dass das Kondenswasser zu einem rückseitigen, tiefer gelegenen Eckbereich des Luftleitbleches fließt.

Zur Ableitung des Kondenswassers ist es zweckmäßig, den rückseitigen tieferen Eckbereich bis zu der benachbarten Gehäuseseitenwand zu führen.

Wenn das Kondenswasser nicht an der Gehäusewand nach unten in eine Kondenswasserrinne oder -wanne fließen soll, kann eine Auffangeinrichtung angeordnet werden, welche mit einer Kondenswasserableitung verbunden ist. Diese kann beispielsweise zur Rückwand geneigt angeordnet sein, so dass das Kondenswasser an der Rückwand entlang nach unten fließen und abgeführt werden kann.

Das erfindungsgemäße Kühlgerät gewährleistet durch die konstruktive Anordnung und Ausbildung des Lamellen-Wärmetauschers und des Luftleitbleches die Ausnutzung der Kohäsionskräfte für eine definierte störungsfreie Ableitung des Kondenswassers. Vorrichtungen zur Kondenswasserabscheidung werden überflüssig, insbesondere, wenn die Strömungsgeschwindigkeit der Luft derart eingestellt wird, dass ein Abreißen der Kondenswassertropfen vermieden und das Kondenswasser in ständigem Kontakt mit den entsprechend ausgebildeten Bauteilen steht. Die in einem Schaltschrank mit Hilfe des Lüfters zurückgeführte, gekühlte Luft enthält keine unkontrolliert mitgerissenen Kondenswassertropfen.

Die Erfindung wird nachstehend anhand einer Zeichnung weiter beschrieben; in dieser zeigen in einer stark schematisierten Darstellung
- Figur 1: eine Ansicht eines erfindungsgemäßen Kühlgerätes im Bereich einer schrankseitigen Gehäusewand;
- Figur 2: eine Seitenansicht nach Pfeil II in Figur 1 und
- Figur 3: eine Seitenansicht einer zweiten Ausbildungsvariante eines erfindungsgemäßen Kühlgerätes.

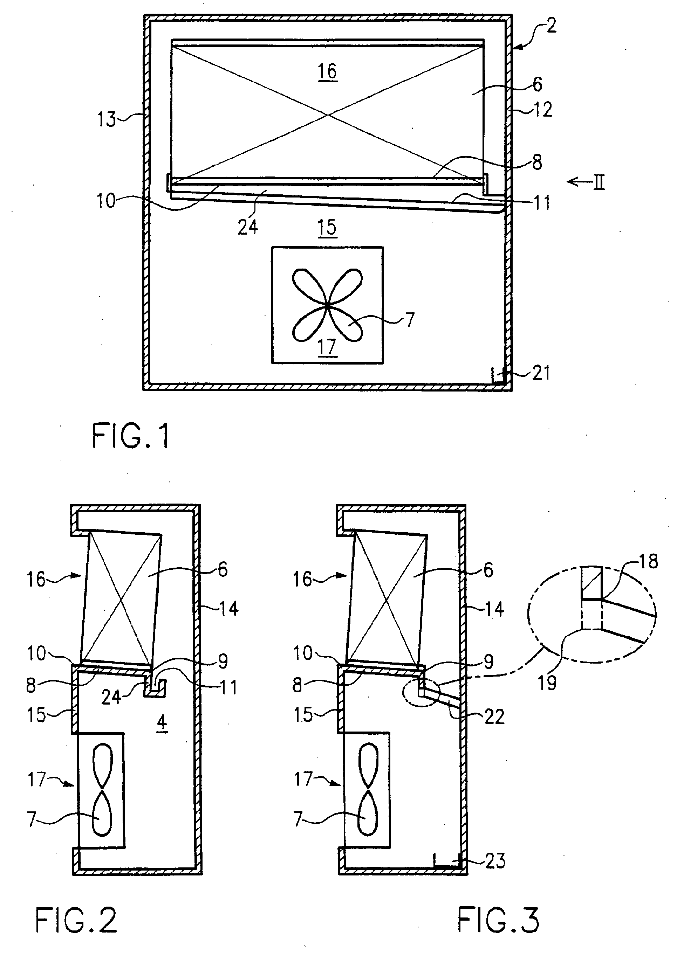

Figur 1 zeigt eine stark schematisierte Ansicht eines Kühlgerätes 2 im Bereich einer schrankseitigen Gehäusewand 15 mit einer Eintrittsöffnung 16 und einer Austrittsöffnung 17. Über die Eintrittsöffnung 16 wird ein Kühlluftstrom aus einem Geräteschrank (nicht dargestellt) einem Verdampfer 6 zugeführt.

Der nur schematisch dargestellte Verdampfer 6 weist vertikal ausgerichtete Kühllamellen auf, die von einem Kühlmittelrohr schlangenförmig quer durchsetzt sind (nicht dargestellt). Die unteren Ränder der Kühllamellen können gegenüber einer Horizontalen unter einem spitzen Winkel geneigt ausgebildet sein.

Der Verdampfer 6 ist auf einem im Wesentlichen horizontalen Luftleitblech 8 derart angeordnet, dass die Lamellen bis zu dem Luftleitblech 8 reichen und dieses kontaktieren. Das sich auf den Kühllamellen niederschlagende Kondenswasser gleitet unter Einwirkung der Schwerkraft zu den unteren Rändern der Lamellen und von diesen auf das Luftleitblech 8.

Das Luftleitblech 8 ist wannenförmig und rückseitig offen ausgebildet und grenzt an eine frontseitige, untere Kante 10 der Lufteintrittsöffnung 16. Mit einer rückseitigen Kante 9 ragt das Luftleitblech 8 in einen Luftführungskanal 4, welcher von der Lufteintrittsöffnung 16 mit dem darin angeordneten Verdampfer 6 für eine nahezu horizontale Luftströmung zu der Luftaustrittsöffnung 17 reicht. Im Bereich der Luftaustrittsöffnung 17 ist ein Gebläse bzw. Ventilator 7 angeordnet, welcher die im Verdampfer 6 gekühlte Kühlluft in den Geräteschrank (nicht dargestellt) zurückführt.

Das sich am Verdampfer 6 niederschlagende Kondenswasser wird durch die nach hinten geneigte Anordnung des Verdampfers 6 und insbesondere des Luftleitbleches 8 zu der rückseitigen Kante 9 geleitet.

Bei der in Figur 1 und Figur 2 gezeigten Ausbildungsvariante ist eine Ablaufrinne 11 unterhalb der rückseitigen Kante 9 angeordnet, in welcher sich das Kondenswasser sammeln kann. In einer fertigungstechnisch besonders vorteilhaften Ausbildung ist die Ablaufrinne 11 an dem Luftleitblech 8 angeformt.

Wie aus Figur 1 hervorgeht, ist die Ablaufrinne 11 geneigt, in diesem Beispiel einseitig geneigt zu einer Gehäuseseitenwand 12 angeordnet und reicht bis an die Gehäuseseitenwand 12 heran. Das sich in der Ablaufrinne 10 ansammelnde Kondenswasser wird somit bis an die Gehäuseseitenwand 12 geführt und kann an dieser durch eine entsprechend ausgebildete Öffnung (nicht dargestellt) an der Innenseite der Gehäuseseitenwand 12 bis zu einer bodenseitig angeordneten Kondenswasserrinne 21 fließen. Die Ablaufrinne 11 ist an einem sich zur Gehäuseseitenwand 12 kontinuierlich verbreiternden Befestigungsschenkel 24 angeordnet.

Figur 1 läßt erkennen, dass die Ablaufrinne 11 auch dachförmig und zu beiden Gehäuseseitenwänden 12, 13 abfallend ausgebildet sein kann. Im Bereich der Seitenwände 12, 13 und insbesondere unterhalb des Lüfters 10 sind dann Ablaufrinnen 21 vorzusehen.

Im Ausführungsbeispiel gemäß Fig. 1 und Fig. 2 sind der Verdampfer 6 und das Luftleitblech 8 nur mit einer zur Rückwand 14 gerichteten Neigung, im Übrigen aber nahezu waagerecht angeordnet. In einer alternativen Ausbildung können der Verdampfer 6 und das Luftleitblech 8 zusätzlich zu einer der Gehäuseseitenwände 12 oder 13 geneigt angeordnet werden und verlaufen dann beispielsweise parallel zu der Ablaufrinne 11 der Fig. 1.

In einer weiteren Ausbildungsvariante gemäß Fig. 3 ist anstelle einer Ablaufrinne 11 an der rückseitigen Kante 9 des nach hinten geneigten Luftleitbleches 8 eine Tropfkante 18 ausgebildet. Diese ist in der gezeigten Ausführungsform vertikal ausgerichtet. Grundsätzlich kann diese auch fluchtend zur Rückseite des Verdampfers 6 bzw. parallel zu dieser Rückseite verlaufen.

Die Tropfkante 18 kann analog zur Ablaufrinne 11 in Richtung einer Gehäuseseitenwand 12 oder 13 sich verbreiternd ausgebildet sein, so dass das daran abfließende Kondenswasser zu einem Abtropfpunkt 19 gelangt. Dieser ist in Figur 3 strichliert gezeigt. Der Abtropfpunkt 19 kann im Bereich einer Seitenwand 12 oder 13 ausgebildet sein, wenn die Tropfkante 18 bis zu wenigstens einer der Gehäuseseitenwände 12, 13 reicht. Das Kondenswasser kann dann an der Innenseite der Gehäuseseitenwand 12 oder 13 bis zu der Kondenswasserrinne 21 abfließen. In Figur 3 ist eine weitere Möglichkeit zur Kondenswasserableitung gezeigt. Bei dieser ist der Abtropfpunkt 19 der Tropfkante 18 über eine Kondenswasserableitung 22 mit der Rückwand 14 verbunden. Das über die schräg nach unten verlaufende Kondenswasserableitung 22 abgeführte Kondenswasser fließt dann an der Innenseite der Rückwand 14 bis in eine bodenseitig angeordnete Kondenswasserwanne 23.

## Patentansprüche

1. Kühlgerät für einen Schaltschrank, mit einem Luftführungskanal (4) für Kühlluft, welche einen Verdampfer (6) mit senkrecht angeordneten Lamellen horizontal durchströmt, und mit einem Luftleitblech (8), welches unterhalb des Verdampfers (6) angeordnet ist und Kondenswasser des Verdampfers (6) aufnimmt,
dadurch **gekennzeichnet,**
dass der Verdampfer (6) auf dem Luftleitblech (8) angeordnet ist und die Lamellen des Verdampfers (6) bis zu dem Luftleitblech (8) reichen und
dass das Luftleitblech (8) und der Verdampfer (6) mit einer zu einer rückseitigen, freien Kante (9) des Luftleitbleches (8) gerichteten Neigung angeordnet sind.

2. Kühlgerät nach Anspruch 1,
dadurch **gekennzeichnet,**
dass für die Kühlluft in einer schrankseitigen Wand (15) eine Eintrittsöffnung (16) und eine Austrittsöffnung (17) vorgesehen sind, dass der Verdampfer (6) in der Eintrittsöffnung (16) und in der Austrittsöffnung (17) unterhalb der Eintrittsöffnung (16) ein Lüfter (7) angeordnet ist.

3. Kühlgerät nach Anspruch 2,
dadurch **gekennzeichnet,**
dass das Luftleitblech (8) wannenartig und rückseitig offen ausgebildet ist, über die gesamte Breite der Eintrittsöffnung (16) und des Verdampfers (6) reicht und frontseitig mit einer unteren Kante (10) der Eintrittsöffnung (16) verbunden ist.

4. Kühlgerät nach einem der vorhergehenden Ansprüche,
**dadurch gekennzeichnet,**
dass die rückseitige Kante (9) des Luftleitblechs (8) mit einer Ablaufrinne (11) für das Kondenswasser versehen ist.

5. Kühlgerät nach Anspruch 4,
dadurch **gekennzeichnet,**
dass die Ablaufrinne (11) mit einer Neigung zu wenigstens einer der Gehäuseseitenwände (12, 13) angeordnet ist.

6. Kühlgerät nach Anspruch 5,
dadurch **gekennzeichnet,**
dass die Ablaufrinne (11) mit wenigstens einem Ende bis zu einer der Gehäuseseitenwände (12, 13) reicht.

7. Kühlgerät nach Anspruch 4 oder 5,
dadurch **gekennzeichnet,**
dass die Ablaufrinne (11) mit wenigstens einem Ende bis zu einer Kondenswasserauffangvorrichtung reicht, welche an eine Kondenswasserableitung (22) angeschlossen ist.

8. Kühlgerät nach einem der Ansprüche 1 bis 3,
dadurch **gekennzeichnet,**
dass das Luftleitblech (8) im Bereich der rückseitigen Kante (9) eine Tropfkante (18) aufweist, welche das Kondenswasser zu wenigstens einem Abtropfpunkt (19) führt.

9. Kühlgerät nach Anspruch 8,
dadurch **gekennzeichnet,**
dass die Tropfkante (18) mit einer Neigung zu einer der Gehäuseseitenwände (12, 13) ausgebildet ist.

10. Kühlgerät nach Anspruch 8 oder 9,
dadurch **gekennzeichnet,**
dass die Tropfkante (18) bis zu wenigstens einer der Gehäuseseitenwände (12, 13) reicht und das Kondenswasser an der Gehäuseseitenwand (12, 13) entlang in eine Kondenswasserrinne (21) fließt, welche unterhalb des Lüfters (7) im Bereich der Gehäuseseitenwände (12, 13) angeordnet ist.

11. Kühlgerät nach einem der Ansprüche 8 bis 10,
dadurch **gekennzeichnet,**
dass der Abtropfpunkt (19) der Tropfkante (13) über eine Kondenswasserableitung (22), welche zur Rückwand (14) geneigt angeordnet ist, mit der Rückwand (14) verbunden ist und das Kondenswasser an der Rückwand (14) entlang in eine Kondenswasserwanne (23) fließt, welche unterhalb des Lüfters (7) im Bereich der Rückwand (14) angeordnet ist.

12. Kühlgerät nach einem der Ansprüche 8 bis 11,
dadurch **gekennzeichnet,**
dass unter dem Abtropfpunkt (19) der Tropfkante (13) eine Auffangvorrichtung angeordnet ist und die Auffangvorrichtung an eine Kondenswasserableitung (22) angeschlossen ist.

13. Kühlgerät nach einem der vorhergehenden Ansprüche,
dadurch **gekennzeichnet,**
dass das Luftleitblech (8) und der Verdampfer (6) mit einer Neigung zu einer der Gehäuseseitenwände (12, 13) angeordnet sind und das Kondenswasser sich in einem rückseitigen, tieferen Eckbereich des Luftleitbleches (8) sammelt.

14. Kühlgerät nach Anspruch 13,
dadurch **gekennzeichnet,**
dass der tiefere Eckbereich des Luftleitbleches (8) bis zu wenigstens einer der angrenzenden Gehäuseseitenwände (12, 13) reicht und das Kondenswasser an den Gehäusewänden (12, 13) entlang in die Kondenswasserrinne (21) fließt, welche unterhalb des Lüfters (7) im Bereich der Gehäuseseitenwände (12, 13) angeordnet ist.

15. Kühlgerät nach Anspruch 13 oder 14,
dadurch **gekennzeichnet,**
dass unter dem tieferen Eckbereich des Luftleitbleches (8) eine Auffangvorrichtung angeordnet ist.

16. Kühlgerät nach Anspruch 15,
dadurch **gekennzeichnet,**
dass die Auffangvorrichtung mit einer der Gehäuseseitenwände (12, 13) verbunden ist und das Kondenswasser an der Gehäuseseitenwand (12, 13) entlang in die Kondenswasserrinne (21) fließt.

17. Kühlgerät nach Anspruch 15 oder 16,
dadurch **gekennzeichnet,**
dass die Auffangvorrichtung an eine Kondenswasserableitung angeschlossen ist.
